(19) Europäisches Patentamt
European Patent Office
Office européen des brevets

(11) **EP 1 840 649 B1**

(12) **EUROPEAN PATENT SPECIFICATION**

(45) Date of publication and mention
of the grant of the patent:
**17.07.2013 Bulletin 2013/29**

(51) Int Cl.:
*G03F 7/00* (2006.01)     *G03F 1/00* (2012.01)
*G03F 9/00* (2006.01)

(21) Application number: **07001653.0**

(22) Date of filing: **12.10.2001**

(54) **Device for holding an imprint lithography template**

Halter für eine Imprint-Lithographiemaske

Dispositif pour tenir un masque de lithographie par impression

(84) Designated Contracting States:
**AT BE CH CY DE DK ES FI FR GB GR IE IT LI LU MC NL PT SE TR**

(30) Priority: **12.10.2000 US 239808 P**

(43) Date of publication of application:
**03.10.2007 Bulletin 2007/40**

(62) Document number(s) of the earlier application(s) in accordance with Art. 76 EPC:
**01273791.2 / 1 352 295**

(73) Proprietor: **Board of Regents, The University of Texas System**
**Austin, TX 78701 (US)**

(72) Inventors:
• **Choi, Byung Jin**
  **Round Rock, TX 78664 (US)**
• **Screenivasans S., V.**
  **Austin, TX 78759 (US)**
• **Bailey, Todd**
  **Fishkill, NY 12524-3935 (US)**
• **Colburn, Matthew**
  **Hopewell Junction, NY 12533-6821 (US)**
• **Willson, C., Grant**
  **Austin, TX 78746 (US)**
• **Ekerdt, John**
  **Austin, TX 78731 (US)**

(74) Representative: **Ponzellini, Gianmarco et al**
**Ponzellini, Gioia e Associati S.r.l.**
**Via Mascheroni, 31**
**20145 Milano (IT)**

(56) References cited:
**EP-A- 0 794 015     EP-A- 0 794 016**
**EP-A2- 1 072 954     US-A- 5 947 027**

• **WHITE D L ET AL: "Novel alignment system for imprint lithography" JOURNAL OF VACUUM SCIENCE AND TECHNOLOGY: PART B, AMERICAN INSTITUTE OF PHYSICS. NEW YORK, US, vol. 18, no. 6, November 2000 (2000-11), pages 3552-3556, XP002204287 44th Intnl. Conf.. on Electron, Ion and Photon Beam Technology and Nanofabrication, 30-May to 2-June 2000, Rancho Mirage, CA, USA ISSN: 0734-211X**

EP 1 840 649 B1

**Description**

The present invention relates to a device for holding an imprint lithography template.

Optical lithography techniques are currently used to make most microelectronic devices. However, it is believed that these methods are reaching their limits in resolution. Sub-micron scale lithography has been a critical process in the microelectronics industry. The use of sub-micron scale lithography allows manufacturers to meet the increased demand for smaller and more densely packed electronic components on chips. It is expected that in the coming years, the microelectronics industry will pursue structures that are smaller than about 50 nm. Further, there are emerging applications of nanometer scale lithography in the areas of opto-electronics and magnetic storage. For example, photonic crystals and high-density patterned magnetic memory of the order of terabytes per square inch require nanometer scale lithography.

For making sub-50 nm structures, optical lithography techniques may require the use of very short wavelengths of light (e. g., about 13.2nm). At these short wavelengths, many common materials may not be optically transparent and therefore imaging systems typically have to be constructed using complicated reflective optics. Furthermore, obtaining a light source that has sufficient output intensity at these wavelengths is difficult. Such systems may lead to extremely complicated equipment and processes that is prohibitively expensive. It is believed that high-resolution e-beam lithography techniques, though very precise, is too slow for high-volume commercial applications.

Imprint lithography processes have demonstrated the ability to replicate high-resolution(sub-50nm) images on substrates using templates that contain images as topography on their surfaces. It is believed that imprint lithography is an alternative to optical lithography for use in patterning substrates in the manufacture of microelectronic devices, optical devices, MEMS, opto-electronics, patterned magnetic media for storage applications, etc. Imprint lithography techniques is superior to optical lithography for making three-dimensional structures such as micro lenses and T-gate structures.

For production-scale imprint lithography, it is desirable to place patterned regions as close as possible to each other without interfering with subsequent imprints. This effectively maximizes the patternable area on the substrate. In order to accomplish this goal, the location of the any excess fluid that is expelled from the patterned area should be well confined and repeatable. As such, the individual components, including the template, substrate, fluid and any other materials that may affect the physical properties of the system, including but not limited to surface energy, interfacial energies, Hamacker constants, Van der Waals'forces, viscosity, density, opacity, etc., should be engineered properly to accommodate a repeatable process. Accordingly, a need exists for a way of controlling the spread of excess fluid outside desired patterning regions that can facilitate production-scale imprint lithography.

The embodiments described herein is directed to template holders as characterized in claim 1. Preferred embodiments are stated in the sub-claims.

To form a pattern on a substrate, a template is placed in a template holder. The template holder may include a body, a supporting plate and at least one piezo actuator. The body may have an opening configured to receive an imprint lithography template. The body is configured to be attached to a template support of an imprint lithography system. The supporting plate is coupled to the body and is substantially transparent to activating light. The supporting plate may span the opening in the body in at least one direction. The supporting plate is formed of materials including but not limited to quartz, sapphire andSi02. The supporting plate is configured to inhibit deformation of a template disposed within the template holder due to forces present in an imprint lithography process. The at least one piezo actuator is coupled to the body, and configured to alter a physical dimension of the imprint lithography template during use. For example, a piezo actuator is configured to apply a compressive or elongating force to a template disposed within the opening. The supporting plate and/or the body may include at least one vacuum opening configured to apply vacuum to a template disposed within the opening and/or the interface of the supporting plate and the body. Additionally, a mirror or reflective coating is applied to a surface of the body that faces inside the opening.

In an example, positioning the patterned template and the substrate in a spaced relationship may include positioning the patterned template over the substrate and moving the patterned template toward the substrate until a desired spaced relationship is achieved. The liquid on the substrate substantially fills the gap as the patterned template is moved toward the substrate. The spaced relationship is a distance of less than about 200nm. In some examples, the patterned template and the substrate is positioned in a substantially parallel orientation. In other examples, the template is positioned over the substrate in a substantially non-parallel position. The template is moved toward the substrate while remaining in a substantially non-parallel orientation with respect to the substrate. The template may then be oriented in a substantially parallel orientation to the substrate when the template is in a desired spaced relationship to the substrate

The substrate may include but is not limited to a dielectric material, silicon, gallium, germanium, indium, quartz, sapphire, silicon dioxide, or polysilicon. The substrate may include one or more layers on the surface of the substrate. In such a case, the method may further include determining a thickness at least one layer on the surface of the substrate. The substrate may also include a transfer layer formed on the surface of the substrate. In such a case, the method may further include etching the transfer layer after separating the template from the cured liquid. Etching the transfer layer may impart the pattern to the transfer layer

The templates may for example, be used to form a semiconductor device, an optical device, a photonic device, a magnetic storage device or thin film head, a display device, etc.

Other objects and advantages of the invention will become apparent upon reading the following detailed description and upon reference to the accompanying drawings in which:

Figures 1A and 1B depict a cross-sectional view of the gap between a template and a substrate;
Figures 2A-2E depict cross-sectional views of an imprint lithography process;
Figure 3 depicts a process flow chart showing the sequence of steps of the imprint lithography process;
Figure 4 depicts a projection view of a substrate support system;
Figure 5 depicts a projection view of an alternate substrate support system;
Figure 6 is a schematic diagram of a 3-link chain connected by flexure joints and joined to a block translating in the X-direction;
Figure 7 is a schematic diagram of an alternate 3-link chain connected by flexure joints and joined to a block translating in the X-direction;
Figure 8 is a projection view of a magnetic linear servo motor;
Figure 9 is a process flow chart of global alignment processing of multiple imprints;
Figure 10 is a process flow chart of field-to-field alignment processing of multiple imprints
Figure 11 depicts a projection view of an orientation stage;
Figure 12 depicts an exploded view of the orientation stage;
Figure 13 depicts a projection view of flexure members;
Figure 14 depicts a first and second flexure member assembled for use ;
Figure 15 depicts a projection view of the bottom of an orientation stage;
Figure 16 depicts a schematic view of a flexure arm holding a template;
Figure 17 depicts a cross-sectional view of a pair of flexure arms and associated precision actuators;
Figure 18 depicts a scheme for forming a vacuum chuck;
Figure 19 depicts various views of a vacuum chuck for holding a substrate;
Figure 20 depicts a scheme for removing a template from a substrate after curing;
Figure 21 depicts an alternative scheme for removing a template from a substrate after curing;
Figure 22 depicts a schematic view of a template support system; and
Figure 23 depicts a side view of a gap between a template and a substrate.

While the invention is susceptible to various modifications and alternative forms, specific embodiments thereof are shown by way of example in the drawing and will herein be described in detail. It should be understood, however, that the drawings and detailed description thereto are not intended to limit the invention to the particular form disclosed, but on the contrary, the intention is as defined by the appended claims.

Embodiments presented herein generally relate to devices, for manufacturing small devices. More specifically, embodiments presented herein relate to devices for imprint lithography. For example, these embodiments may have application to imprinting very small features on a substrate, such as a semiconductor wafer. It should be understood that these embodiments may also have application to other tasks, for example, the manufacture of cost-effective Micro-Electro-Mechanical Systems (or MEMS). Embodiments may also have application to the manufacture of other kinds of devices including, but not limited to: patterned magnetic media for data storage, micro-optical devices, biological and chemical devices, X-ray optical devices, etc.

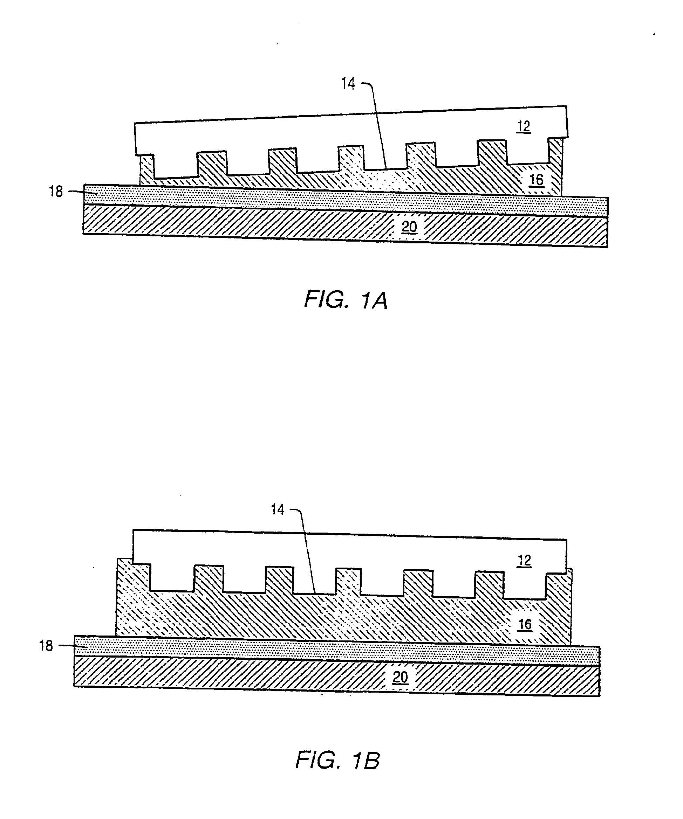

With reference now to the figures, and specifically to Figures 1A and 1B, therein are shown arrangements of a template 12 predisposed with respect to a substrate 20 upon which desired features are to be imprinted using imprint lithography. Specifically, the template 12 may include a surface 14 fabricated to take on the shape of desired features, which in turn, are transferred to the substrate 20. As used herein, a "feature size" generally refers to a width or depth of one of a desired features. In some examples, a transfer layer 18 is placed between the substrate 20 and the template 12. Transfer layer 18 may receive the desired features from the template 12 via imprinted layer 16. As is well known in the art, transfer layer 18 may allow one to obtain high aspect ratio structures (or features) from low aspect ratio imprinted features.

For the purpose of imprint lithography, it is important to maintain the template 12 and substrate 20 as close to each other as possible and nearly parallel. For example, for features that are about 100mm wide and about 100nm deep, an average gap of about 200nm or less with a variation of less than about 50nm across the imprinting area of the substrate 20 is required for the imprint lithography process to be successful. Examples presented herein provide a way of controlling the spacing between the template 12 and substrate 20 for successful imprint lithography given such tight and precise gap requirements.

Figures 1A and 1B illustrate two types of problems that are encountered in imprint lithography. In Figure1A, a wedge shaped imprinted layer 16 results because that the template 12 is closer to the substrate 20 at one end of the imprinted layer 16. Figure 1A illustrates the importance of maintaining template 12 and substrate 20 substantially parallel during pattern transfer. Figure 1B shows the imprinted layer 16 being too thick. Both of these conditions is highly undesirable. Examples presented herein provide systems, processes and related devices which may eliminating the conditions illustrated in Figures 1A and 1B as well as other orientation problems associated with prior art lithography techniques.

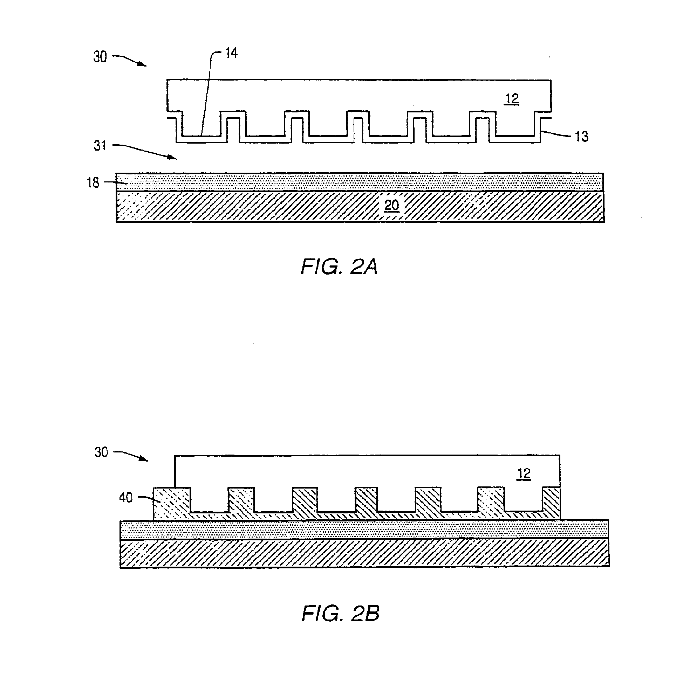

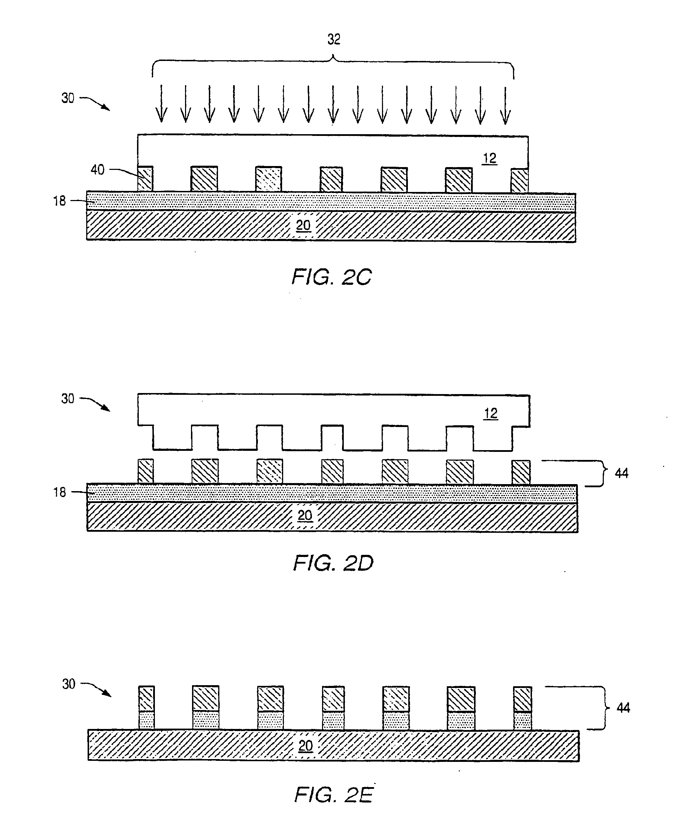

Figures 2A through 2E illustrate an example of an imprint lithography process, denoted generally as 30. In Figure 2A, template 12 is orientated in spaced relation to the substrate 20 so that a gap 31 is formed in the space separating template 12 and substrate 20. Surface 14 of template 12 is treated with a thin layer 13 that lowers the template surface energy and assists in separation of template 12 from substrate 20. The manner of orientation and devices for controlling gap 31 between template 12 and substrate 20 are discussed below. Next, gap 31 is filled with a substance 40 that conforms to the shape of treated surface 14. Alternately, substance 40 is dispensed upon substrate 20 prior to moving template 12 into a desired position relative to substrate 20.

Substance 40 may form an imprinted layer such as imprinted layer 16 shown in Figures 1A and 1B. Preferably, substance 40 is a liquid so that it may fill the space of gap 31 rather easily and quickly without the use of high temperatures and the gap can be closed without requiring high pressures. Further details regarding appropriate selections for substance 40 are discussed below.

A curing agent 32 is applied to the template 12 causing substance 40 to harden and assume the shape of the space defined by gap31. In this way, desired features 44 (Figure 2D) from the template 12 are transferred to the upper surface of the substrate 20. Transfer layer 18 is provided directly on the upper surface of substrate 20. Transfer layer 18 may facilitate the amplification of features transferred from the template 12 to generate high aspect ratio features.

As depicted in Figure 2D, template 12 is removed from substrate 20 leaving the desired features 44 thereon. The separation of template 12 from substrate 20 must be done so that desired features 44 remain intact without shearing or tearing from the surface of the substrate 20. Examples presented herein describe a method and associated system for peeling and pulling (referred to herein as the "peel-and-pull" method) template 12 from substrate 20 following imprinting so that desired feature 44 remain intact.

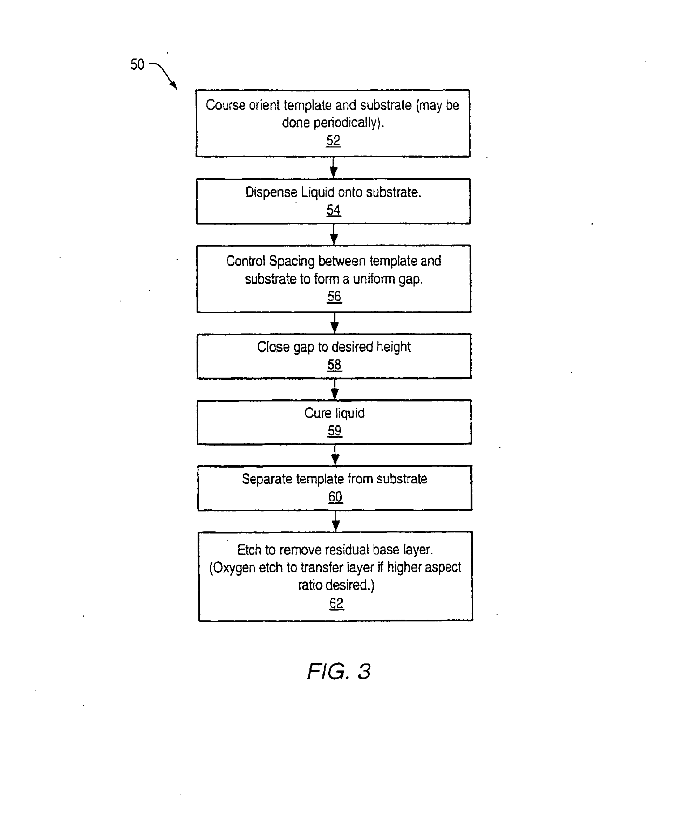

Finally, in Figure 2E, features 44 transferred from template 12 to substance 40 are amplified in vertical size by the action of the transfer layer 18 as is known in the use of bi-layer resist processes. The resulting structure is further processed to complete the manufacturing process using well-known techniques. Figure 3 summarizes an example of an imprint lithography process, denoted generally as 50, in flow chart form. Initially, at step 52, course orientation of a template and a substrate is performed so that a rough alignment of the template and substrate is achieved. An advantage of course orientation at step 52 is that it may allow pre-calibration in a manufacturing environment, where numerous devices are to be manufactured, with efficiency and with high production yields. For example, where the substrate includes one of many die on a semiconductor wafer, course alignment (step 52) is performed once on the first die and applied to all other dies during a single production run. In this way, production cycle times are reduced and yields are increased.

At step 54, a substance is dispensed onto the substrate. The substance is a curable organosilicon solution or other organic liquid that iscome a solid when exposed to activating light. The fact that a liquid is used may eliminate the need for high temperatures and high pressures associated with prior art lithography techniques. Next, at step 56, the spacing between the template and substrate is controlled so that a relatively uniform gap is created between the two layers permitting the precise orientation required for successful imprinting. Examples presented herein provide a device and system for achieving the orientation (both course and fine) required at step 56.

At step 58, the gap is closed with fine vertical motion of the template with respect to the substrate and the substance. The substance is cured (step 59) resulting in a hardening of the substance into a form having the features of the template. Next, the template is separated from the substrate, step 60, resulting in features from the template being imprinted or transferred onto the substrate. Finally, the structure is etched, step 62, using a preliminary etch to remove residual material and a well-known oxygen etching technique to etch the transfer layer.

In various examples, a template may incorporate unpatterned regions i) in a plane with the template surface, ii) recessed in the template, iii) protrude from the template, or iv) a combination of the above. A template is manufactured with protrusions, which are rigid. Such protrusions may provide a uniform spacer layer useful for particle tolerance and optical devices such as gratings, holograms, etc. Alternately, a template is manufactured with protrusions that are compressible.

In general, a template may have a rigid body supporting it via surface contact from: i) the sides, ii) the back, iii) the front or iv) a combination of the above. The template support may have the advantage of limiting template deformation or distortion under applied pressure. In some examples, a template is coated in some regions with a reflective coating. In some such examples, the template may incorporate holes in the reflective coating such that light may pass into or through the template. Such coatings are useful in locating the template for overlay corrections using interferometry. Such coatings may also allow curing with a curing agent sources that illuminates through the sides of the template rather than the top. This may allow flexibility in the design of a template holder, of gap sensing techniques, and of overlay mark detection systems, among other things. Exposure of the template is performed: i) at normal incidences to the template, ii) at inclined angles to the template, or iii) through a side surface of the template. In some examples, a template that is rigid is used in combination with a flexible substrate.

The template is manufactured using optical lithography, electron beam lithography, ion-beam lithography, x-ray lithography, extreme ultraviolet lithography, scanning probe lithography, focused ion beam milling, interferometric lithography, epitaxial growth, thin film deposition, chemical etch, plasma etch, ion milling, reactive ion etch or a combination of the above. The template is formed on a substrate having a flat, parabolic, spherical, or other surface topography. The template is used with a substrate having a flat, parabolic, spherical, or other surface topography. The substrate may contain a previously patterned topography and/or a film stack of multiple materials.

Successful imprint lithography may require precise alignment and orientation of the template with respect to the substrate to control the gap in between the template and substrate. Examples presented herein may provide a system capable of achieving precise alignment and gap control in a production fabrication process. In an example, the system may include a high resolution X-Y translation stage. In an example, the system may provide a pre-calibration stage for performing a preliminary and course alignment operation between the template and substrate surface to bring the relative alignment to within the motion range of a fine movement orientation stage. This pre-calibration stage is required only when a new template is installed into the apparatus (also sometimes known as a stepper). The pre-calibration stage may consist of a base plate, a flexure component, and a plurality of micrometers or high-resolution actuators coupling the base plate and the flexure component.

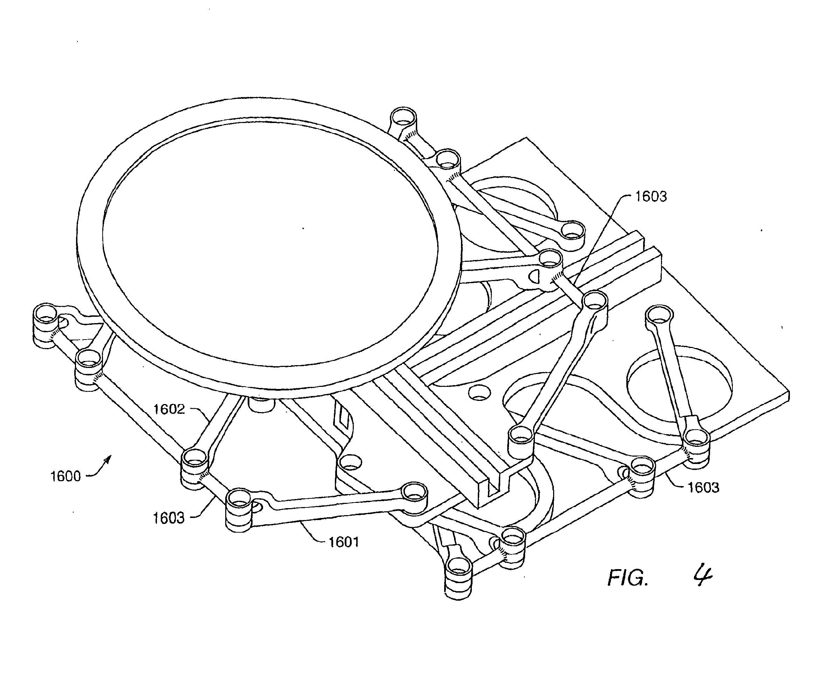

Figure 4 depicts an example of an X-Y translation stage in an assembled configuration, and generally referenced by numeral 1600. The overall footprint is less than about 20 inches by 20 inches and the height is about 6 inches (including a wafer chuck). Such an example may provide X and Y-axis translation ranges of motion of about 12 inches.

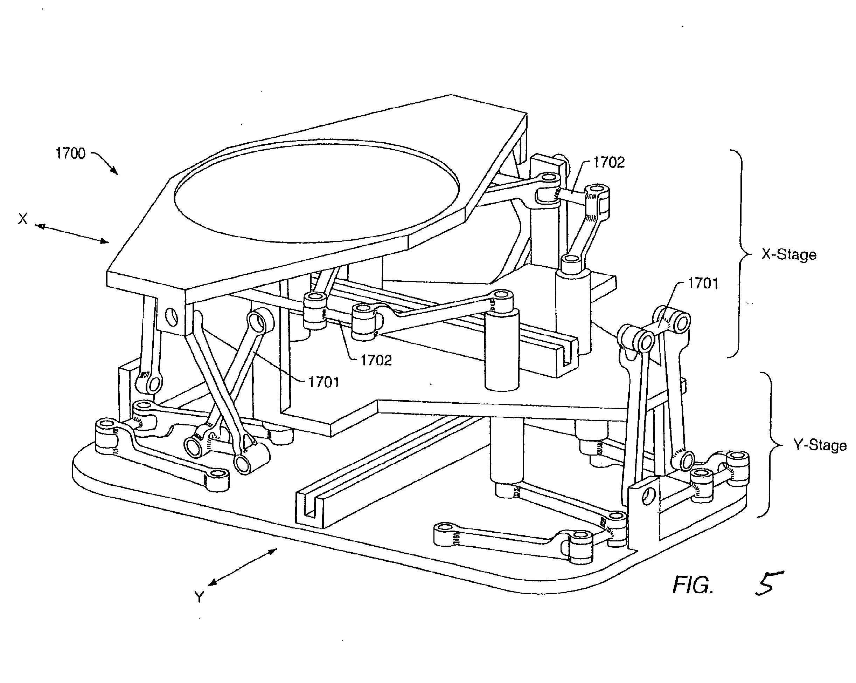

A second example of an X-Y translation stage is depicted in Figure 5, and generally referenced by numeral 1700. To provide a similar range of motion to that of X-Y stage 1600, stage 1700 may have a foot print of about 29 inches by 29 inches and a height of about 15 inches (including a wafer chuck). Stages 1600 and 1700 differ mainly in that additional linkages 1701 are oriented vertically.

Both X-Y stage 1600 and X-Y stage 1700 are flexure based systems. Flexures are widely used in precision machines since they may offer frictionless, particle-free and low maintenance operation. Flexures may also provide extremely high resolution. Examples of flexure based systems are disclosed in U. S. Patents 4,694,703 to Routson and 4062,600 to Wyse . However, most flexure based systems may possess limited ranges of motion (e. g., sub mm range of motion). Examples disclosed herein may have a range of motion of more than 12 inches. It is believed that such stages are cost effective for lithographic applications, particularly in vacuum. Further, for imprint lithography techniques, the presence of imprint forces may give examples presented herein significant advantages.

In general, an X-Y stage may include two types of components: actuation components and load-carrying components. Lead screw assembly mechanisms have been widely used where the positioning accuracy is not a very significant factor. For high accuracy applications, ball screw assemblies have been used for both the actuating and load-carrying components. Both of these designs are prone to problems of backlash and stiction. Further, the need for lubrication may make these designs undesirable for use in vacuum or in particle-sensitive applications (e. g., imprint lithography).

Additionally, some designs may utilize air bearings. Air bearings may substantially eliminate problems of stiction and backlash. However, air bearings may provide limited load bearing capacities. Additionally, air bearings are unsuitable for use in vacuum environments.

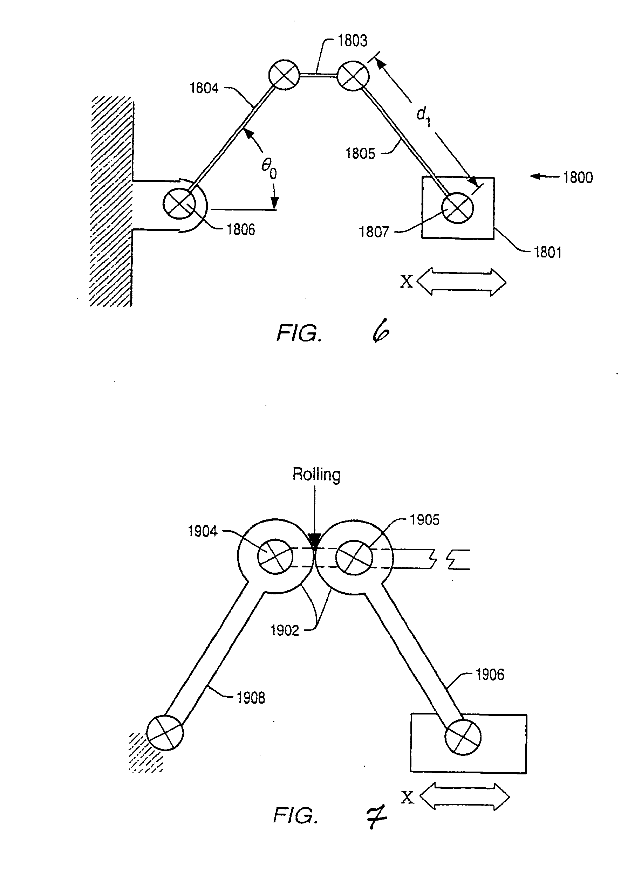

Figure 6 shows a schematic of portion of a basic linkage 1800. Link 1 (1804) and link 3 (1805) is of the same length. When a moving body 1801 moves along the X-axis, all of the joints in linkage 1800 rotate by the same absolute angle. It should be noted that the motion range can independent of the length of link 2 (1803). Due to kinematic constraints, link 2 (1803) may remain parallel to a line between joint 1 (1806) and joint 4 (1807). In linkage 1800, the range of motion, /m, is given as:

$$l_m = 2 d_1 [\cos(\theta_0 - \alpha_{max}/2) - \cos(\theta_0 + \alpha_{max}/2)]$$
$$= 4 d_1 \sin(\theta_0) \sin(\alpha_{max}/2),$$

where, $\theta_0$ is the angle of joint 1 (1806) when all flexure joints are in their equilibrium conditions, $\alpha_{max}$ is the maximum rotation range of the flexure pivots, and $d_1$ is the length of links 1 and 3, 1804 and 1805. As shown in the above equation, for given $d_1$, the motion range is maximized when $\theta_0 = 90$ Degree. Therefore, the link length is given as:

$$d_1 \quad = \quad l_m/[4\sin(\alpha_{max}/2)]$$

Therefore, using an $\alpha_{max}$ of 60° , the minimum link length for a 12 inch motion range, is 6 inches.

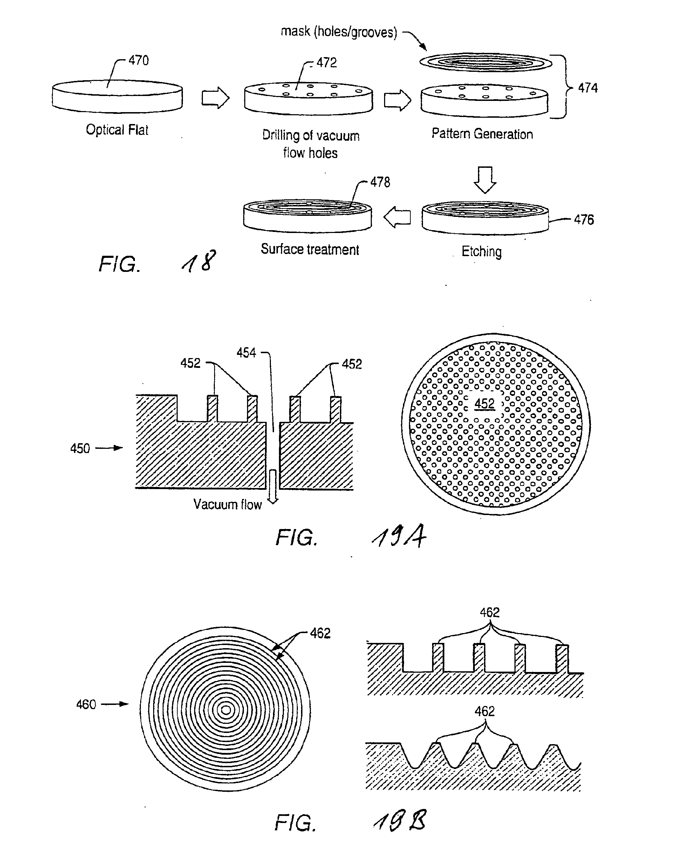

Figure 7 depicts an example of a basic linkage similar to linkage 1800, but with the addition of two cylindrical disks 1902. A kinematic study shows that if joint 2 (1904) and joint 3 (1905) of Figure 7 rotate in opposite directions by the same angle, the stage may generate a pure translational motion along the X axis. By adding cylindrical disks 1902 at flexure joints 2 (1904) and 3 (1905), the resulting rolling contact may rotate link 1 (1908) and link 2 (1906) in opposite directions. In an example, no additional joints or bearings are required since cylindrical discs 1902 are coupled to links 1908 and 1906. In order to prevent discs 1902 from slipping, an appropriate pre-load is applied between the two disks. Compared to conventional stages where direct driven mechanisms or bearings are used, the contact surface here is relatively small, and relatively easy to maintain. Note that although disks 1902 are not depicted in relation to X-Y stages 1600, and 1700, disks 1902 is present in some examples. Links 1602 and 1601 in Figure 4 may correspond to links 1908 and 1906 of Fig. 19. Thus, disks 1902 are present at location 1603 (as well as other locations not visible in the Figure 4). Referring to Figure 5, disks 1902 are present at location 1702 (as well as other locations not visible in Figure 5).

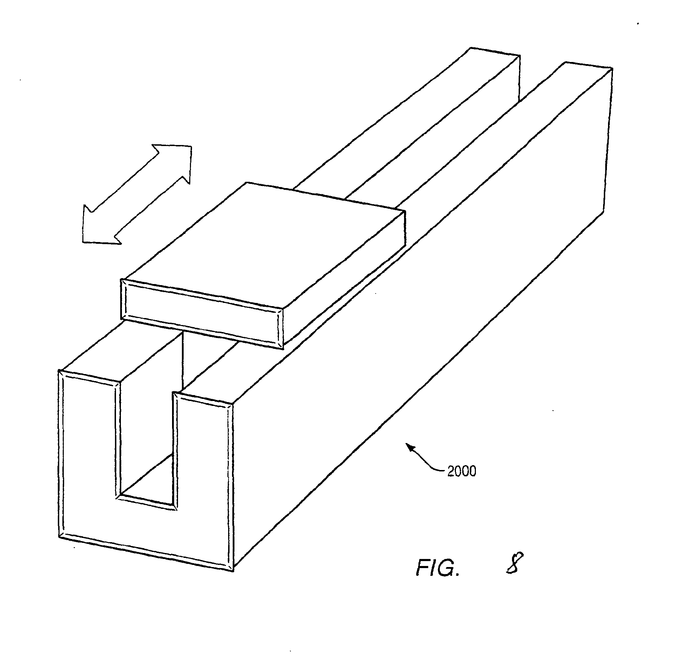

As the actuation system for either of stages 1600 or 1700, two linear servo motors (as depicted in Figure 8 and referenced by numeral 2000) is suitable. One linear servo motor may serve each translation axis. Suitable linear servo motors are available from the Trilogy Systems Corporation. An advantage of such linear servo motors is the absence of frictional contact. Another advantage of such linear servo motors is the fact that they may readily produce actuation forces greater than about 100 pounds. Therefore, actuation components may provide only translational motion control in the X and Y directions. It should be noted that in some examples, the actuator of the lower stage might need to be more powerful than the actuator of the upper stage. In some examples, laser interferometers may provide a feedback signal to control X and Y positioning of the X-Y stage. It is believed that laser interferometry may provide nm level positioning control.

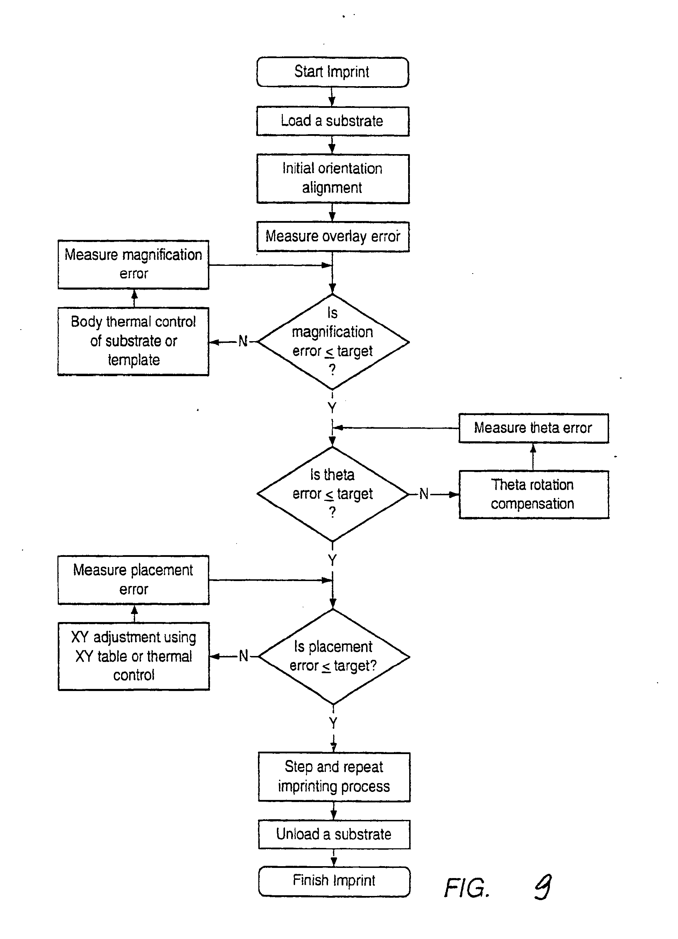

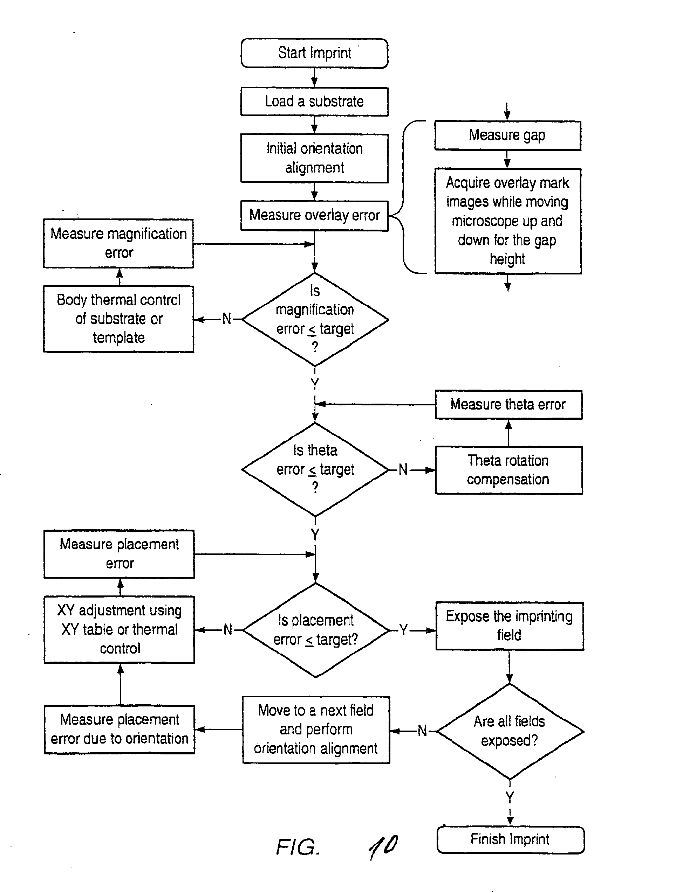

Placement errors can be compensated using laser interferometers and high-resolution X-Y stages (such as X-Y stage 1700, depicted in Figure 5). If the orientation alignments between the template and substrate are independent from X-Y motions the placement error may need to be compensated only once for an entire substrate wafer (i. e. "global overlay"). If orientation alignments between the template and substrate are coupled with X-Y motions and/or excessive local orientation variations on substrate exist, then X-Y position changes of the template relative to the substrate may need to be compensated for (i. e., field-to-field overlay). Overlay alignment issues are further discussed with regard the overlay alignment section. Figures 9 and 10 provide global and field-to-field overlay error compensation algorithms, respectively.

In an example, orientation of template and substrate is achieved by a pre-calibration stage (automatically, using actuators or manual, using micrometers) and a fine orientation stage, which is active or passive. Either or both of these stages may include other mechanisms, but flexure-based mechanisms are preferred in order to avoid particles. The calibration stage is mounted to a frame, and the fine orientation stage is mounted to the pre-calibration stage. Such an example may thereby form a serial mechanical arrangement.

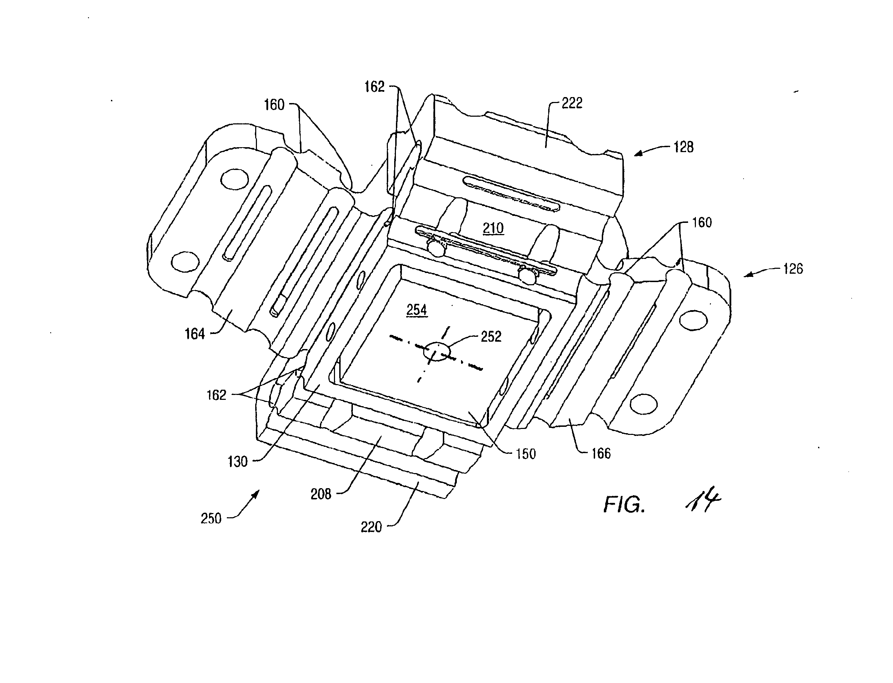

A fine orientation stage may include one or more passive compliant members. A "passive compliant member" generally refers to a member that gets its motion from compliance. Compliant members apparatus are disclosed in U. S. Patents 4,414,750; 4,337,579; 4,155,169; 4,355,469; 4,202,107; and 4,098,001. That is, motion is activated by direct or indirect contact with the liquid. If the fine orientation stage is passive, then it is designed to have the most dominant compliance about two orientation axes. The two orientation axes are orthogonal and may lie on the template lower surface (as described with referenced to Figure 14). The two orthogonal torsional compliance values may typically be the same for a square template. The fine orientation stage is designed such that when the template is non-parallel with respect to the substrate, as it makes contact with the liquid, the resulting uneven liquid pressure may rapidly correct the orientation error. In an example, the correction is affected with minimal or no overshoot. Further, a fine orientation stage as described above may hold the substantially parallel orientation between the template and substrate for a sufficiently long period to allow curing of the liquid.

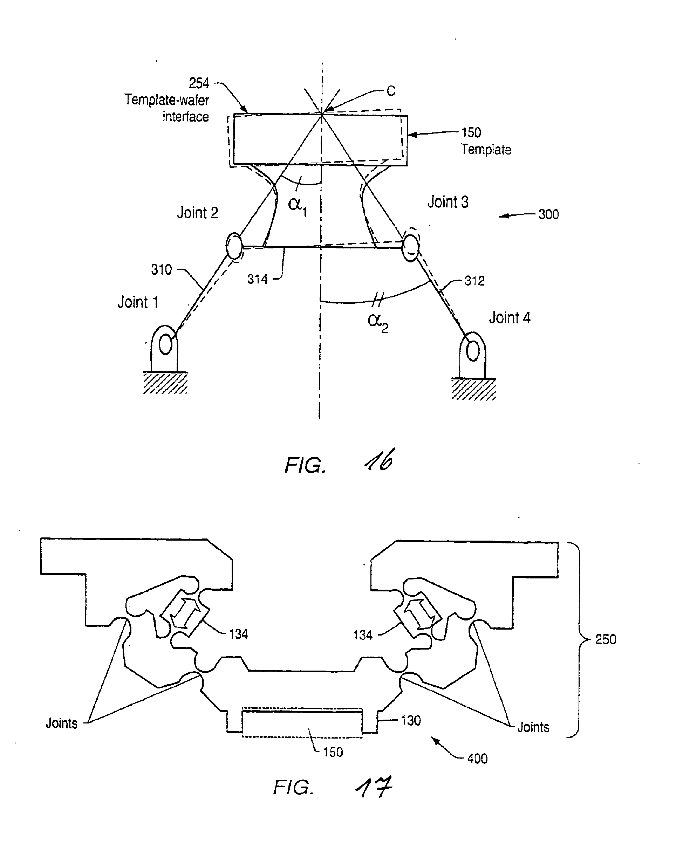

In an example, a fine orientation stage may include one or more actuators. For example, piezo actuators (as described with reference to Figure 17) are suitable. In such an example, the effective passive compliance of the fine orientation stage coupled with the pre-calibration stage should still be substantially about the two orientation axes. The geometric and material parameters of all the structural and active elements together may contribute to this effective passive stiffness. For instance, piezo actuators may also be compliant in tension and compression. The geometric and material parameters are synthesized to obtain the desired torsional compliance about the two orientation axes. A simple approach to this synthesis is to make the compliance of the actuators along their actuation direction in the fine orientation stage higher than the structural compliances in the rest of the stage system. This may provide passive self-correction capability when a non-parallel template comes into contact with the liquid on the substrate. Further, this compliance should be chosen to allow for rapidly correcting orientation errors, with minimal or no overshoot. The fine orientation stage may hold the substantially parallel orientation between the template and substrate for sufficiently long period to allow curing of the liquid.

Overlay alignment schemes may include measurement of alignment errors followed by compensation of these errors to achieve accurate alignment of an imprint template, and a desired imprint location on a substrate. The measurement techniques used in proximity lithography, x-ray lithography, and photolithography (e. g., laser interferometry, capacitance sensing, automated image processing of overlay marks on the mask and substrate, etc.) is adapted for the imprint lithography process with appropriate modifications. A method and system of overlay alignment using a stored image is disclosed in U. S. Patent 5,204,739.

Types of overlay errors for lithography processes may include placement error, theta error, magnification error, and mask distortion error. An advantage of examples disclosed herein is that mask distortion errors may not be present because the disclosed processes may operate at relatively low temperatures (e. g., room temperature) and low pressures. Therefore, these examples may not induce significant distortion. Further, these examples may use templates that are made of a relatively thick substrate. This may lead to much smaller mask (or template) distortion errors as compared to other lithography processes where masks are made of relatively thin substrates. Further, the entire area of the templates for imprint lithography processes is transparent to the curing agent (e. g., W light), which may minimize heating due to absorption of energy from the curing agent. The reduced heating may minimize the occurrence of heat-induced distortions compared to photolithography processes where a significant portion of the bottom surface of a mask is opaque due to the presence of a metallic coating.

Placement error may generally refer to X-Y positioning errors between a template and substrate (that is, translation along the X and/or Y-axis). Theta error may generally refer to the relative orientation error about Z-axis (that is, rotation about the Z-axis). Magnification error may generally refer to thermal, optical or material induced shrinkage or expansion of the imprinted area as compared to the original patterned area on the template.

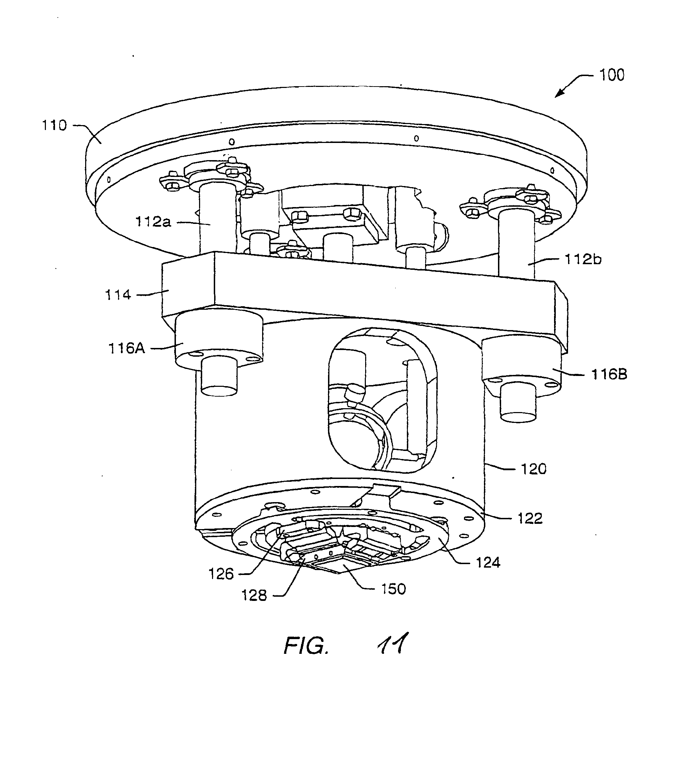

Figure 11, depicts an assembly of a system, denoted generally as 100, for calibrating and orienting a template, such as template 12, about a substrate to be imprinted, such as substrate 20. System 100 is utilized in a machine, such as a stepper, for mass fabrication of devices in a production environment using imprint lithography processes as described herein. As shown, system 100 is mounted to a top frame 110 which may provide support for a housing 120. Housing 120 may contain the pre-calibration stage for course alignment of a template 150 about a substrate (not shown in Figure 11).

Housing 120 is coupled to a middle frame 114 with guide shafts 112a, 112b attached to middle frame 114 opposite housing 120. In one example, three (3) guide shafts are used (the back guide shaft is not visible in Figure 11) to provide a support for housing 120 as it slides up and down during vertical translation of template 150. Sliders 116a and116b attached to corresponding guide shafts 112a, 112b about middle frame 114 may facilitate this up and down motion of housing 120.

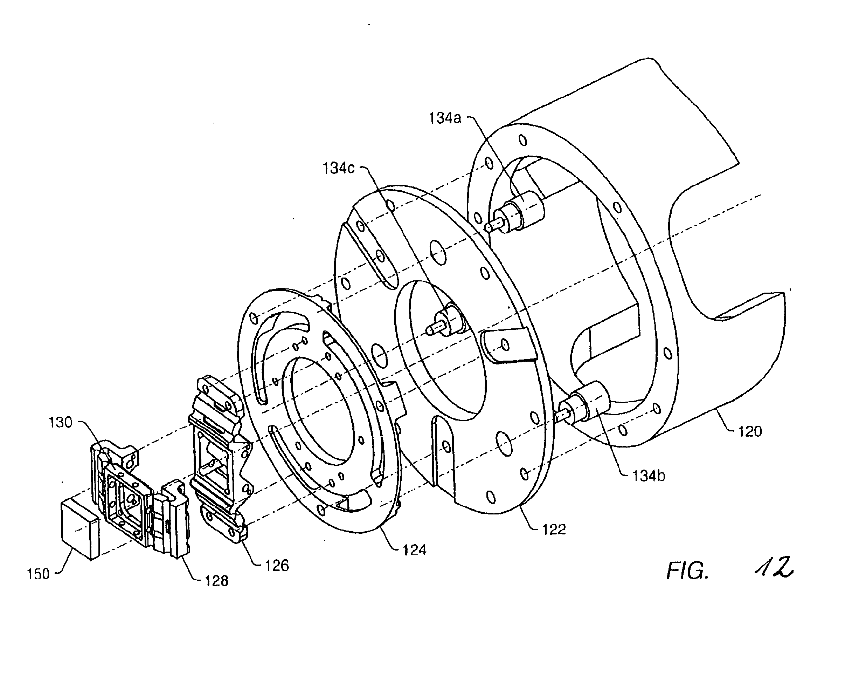

System 100 may include a disk-shaped base plate 122 attached to the bottom portion of housing 120. Base plate 122 is coupled to a disk-shaped flexure ring 124. Flexure ring 124 may support the lower placed orientation stage included of first flexure member 126 and second flexure member 128. The operation and configuration of the flexure members 126,128 are discussed in detail below. As depicted in Figure 12, the second flexure member 128 may include a template support 130, which may hold template 150 in place during the imprinting process. Typically, template 150 may include a piece of quartz with desired features imprinted on it.

Template 150 may also include other substances according to well-known methods.

As shown in Figure 12, actuators 134a, 134b, 134c are fixed within housing 120 and operable coupled to base plate 122 and flexure ring 124. In operation, actuators 134a, 134b, 134c are controlled such that motion of the flexure ring 124 is achieved. Motion of the actuators may allow for coarse pre-calibration. In some examples, actuators 134a, 134b, 134c may include high-resolution actuators. In such examples, the actuators are equally spaced around housing 120. Such an example may permit very precise translation of the ring 124 in the vertical direction to control the gap accurately. Thus, the system 100 is capable of achieving coarse orientation alignment and precise gap control of template 150 with respect to a substrate to be imprinted.

System 100 may include a mechanism that enables precise control of template 150 so that precise orientation alignment is achieved and a uniform gap is maintained by the template with respect to a substrate surface. Additionally, system 100 may provide a way of separating template 150 from the surface of the substrate following imprinting without shearing of features from the substrate surface. Precise alignment and gap control is facilitated by the configuration of the first and second flexure members, 126 and 128, respectively.

WHITE D L ET AL: "Novel alignment system for imprint lithography" JOURNAL OF VACUUM SCIENCE AND TECHNOLOGY: PART B, AMERICAN INSTITUTE OF PHYSICS NEW YORK, US, vol. 18, no. 6, November 2000 (2000-11), pages 3552-3556, describes a device for holding an imprint template comprising a body with an opening wherein a piezo system is coupled to the device body in order to vary the dimensions of the template.

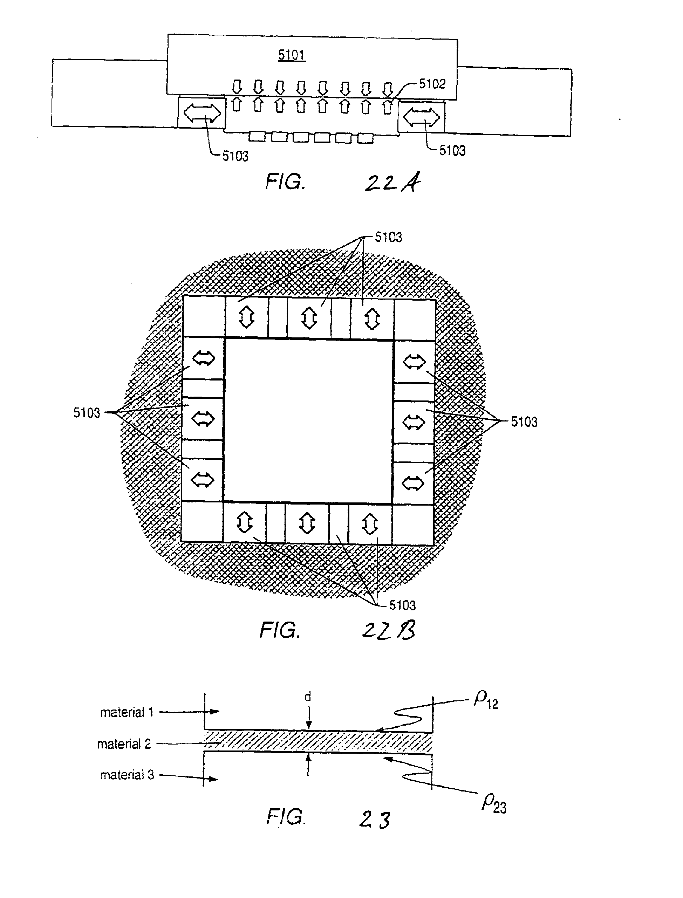

In the invention, template 5102 is held in place using a separated, fixed supporting plate5101 that is transparent to the curing agent as depicted in Figure 22. In various embodiments, the supporting plate is formed of quartz, sapphire orSiO2. While supporting plate5101 behind template 5102 may support the imprinting force, applying vacuum between fixed supporting plate5101 and template 5102 may support the separation force. Additionally, vacuum is used to couple the supporting plate to the body of the template holder. In order to support template 5102 for lateral forces, piezo actuators 5103 are used. The lateral supporting forces are carefully controlled by using piezo actuators 5103. This design may also provide the magnification and distortion correction capability for layer-to-layer alignment in imprint lithography processes. Distortion correction are very important to overcome stitching and placement errors present in the template structures made by electron beam lithography, and to compensate for distortion in the previous structures present on the substrate. Magnification correction may only require one piezo actuator on each side of the template (i. e. total of 4 piezo actuators for a four sided template). The actuators is connected to the template surface in such a way that a uniform force is applied on the entire surface. Distortion correction, on the other hand, may require several independent piezo actuators that apply independently controlled forces on each side of the template.

Depending on the level of distortion control required, the number of independent piezo actuators is specified. More piezo actuators provide better control of distortion. The magnification and distortion error correction should be completed prior to the use of vacuum to constrain the top surface of the template. This is because magnification and distortion correction is properly controlled only if both the top and bottom surfaces of the template are unconstrained. In some embodiments, the template holder system of Figure 22 has a mechanical design that causes obstruction of the curing agent to a portion of the area under template 5102. This is undesirable because a portion of the liquid below template 5102 may not cure. This liquid can stick to the template causing problems with further use of the template. This problem with the template holder is avoided by incorporating a set of mirrors into the template holder to divert the obstructed curing agent in such a way that curing agent directed to the region below one edge of template 5102 is bent to cure an obstructed portion below the other edge of template 5102.

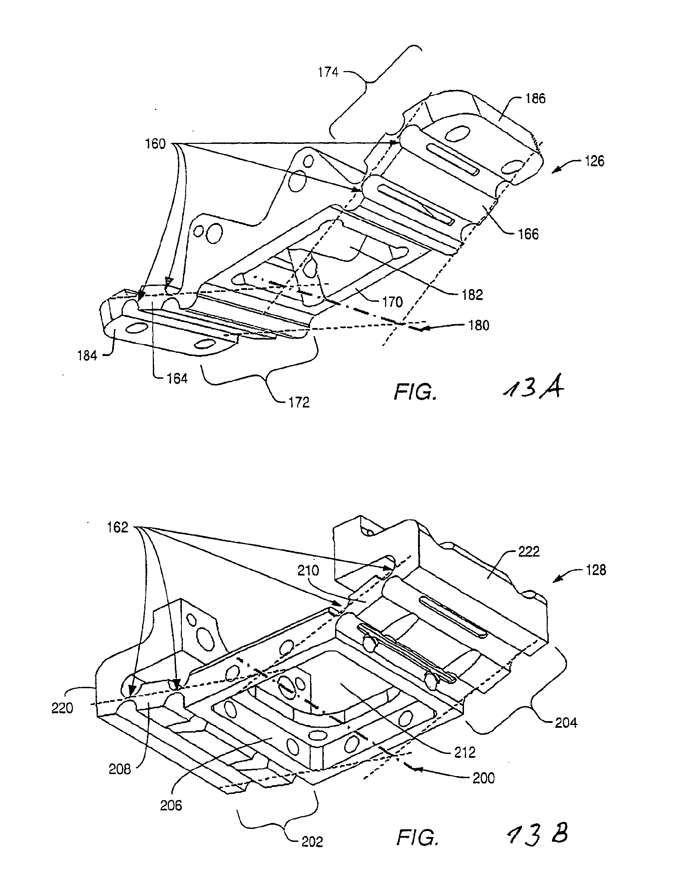

With reference to Figures 13A and 13B, therein are depicted examples of the first and second flexure members, 126 and 128, respectively, in more detail. Specifically, the first flexure member 126 includes a plurality of flexure joints 160 coupled to corresponding rigid bodies 164,166. Flexure joints 160 and rigid bodies 164, and 166 forms part of arms 172,174 extending from a frame 170. Flexure frame 170 has an opening 182, which permits the penetration of a curing agent (e. g., activating light) and a sensing agent (e. g., analyzing light) to reach the template 150 when held in support 130. In some examples, four (4) flexure joints 160 provide motion of the flexure member 126 about a first orientation axis 180. Frame 170 of first flexure member 126 provides a coupling mechanism for joining with second flexure member 128 as illustrated in Figure 14.

Likewise, second flexure member128 includes a pair of arms 202,204 extending from a frame 206. Arms 202 and 204 include flexure joints 162 and corresponding rigid bodies 208,210. Rigid bodies 208 and210 is adapted to cause motion of flexure member 128 about a second orientation axis 200. A template support 130 is integrated with frame 206 of the second flexure member 128. Like frame 182, frame 206 has an opening 212 permitting a curing agent and a sensing agent to reach template 150 which is held by support 130.

In operation, first flexure member 126 and second flexure member 128 is joined as shown in Figure 14 to form orientation stage 250. Braces 220,222 is provided in order to facilitate joining of the two pieces such that the first orientation axis 180 and second orientation axis 200 are substantially orthogonal to each other. In such a configuration, first orientation axis 180 and second orientation intersect at a pivot point 252 at approximately the template substrate interface 254. The fact that first orientation axis 180 and second orientation axis 200 are orthogonal and lie on interface 254 provides fine alignment and gap control. Specifically, with this arrangement, a decoupling of orientation alignment from layer-to-layer overlay alignment is achieved.

Furthermore, as explained below, the relative position of first orientation axis 180 and second orientation axis 200 provides an orientation stage 250 that is used to separate the template 150 from a substrate without shearing of desired features. Thus, features transferred from the template 150 may remain intact on the substrate.

Referring to Figures 13A, 13B and 14, flexure joints 160 and 162 is notched shaped to provide motion of rigid bodies 164,166,208,210 about pivot axes that are located along the thinnest cross section of the notches. This configuration provides two (2) flexure-based sub-systems for a fine decoupled orientation stage 250 having decoupled compliant motion axes 180,200. Flexure members 126,128 is assembled via mating of surfaces such that motion of template 150 occurs about pivot point 252 substantially eliminating "swinging" and other motions that could shear imprinted features from the substrate. Thus, orientation stage 250 precisely moves the template 150 about a pivot point 252 ; thereby, eliminates shearing of desired features from a substrate following imprint lithography.

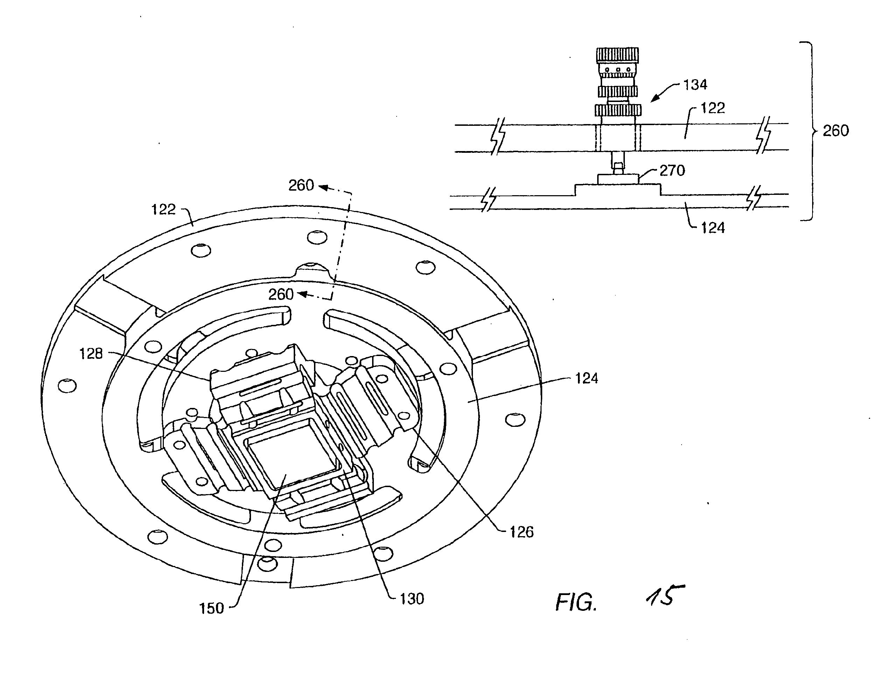

Referring to Figure 15, during operation of system 100, a Z-translation stage (not shown) controls the distance between template 150 and the substrate without providing orientation alignment. A pre-calibration stage 260 performs a preliminary alignment operation between template 150 and the substrate surfaces to bring the relative alignment to within the motion range limits of orientation stage 250. In certain examples, precalibration is required only when a new template is installed into the machine.

With reference to Figure 16, therein is depicted a flexure model, denoted generally as 300, useful in understanding the principles of operation of a fine decoupled orientation stage, such as orientation stage 250. Flexure model 300 includes four (4) parallel joints: joints 1,2,3 and 4, that provide a four-bar-linkage system in its nominal and rotated configurations. Line 310 passes though joints 1 and 2. Line 312 passes through joints 3 and 4. Angles $\alpha_1$, and $\alpha_2$ is selected so that the compliant alignment (or orientation axis) axis lies substantially on the template-wafer interface 254. For fine orientation changes, rigid body 314 between Joints 2 and 3 may rotate about an axis depicted by Point C. Rigid body 314 is representative of rigid bodies 170 and 206 of flexure members 126 and 128.

Mounting a second flexure component orthogonally onto the first one (as depicted in Figure 14) provides a device with two decoupled orientation axes that are orthogonal to each other and lie on the template-substrate interface 254. The flexure components is adapted to have openings to allow a curing agent (e. g. activating light) and a sensing agent (e. g. analyzing light) to pass through the template 150.

The orientation stage 250 is capable of fine alignment and precise motion of template 150 with respect to a substrate. Ideally, the orientation adjustment leads to negligible lateral motion at the interface and negligible twisting motion about the normal to the interface surface due to selectively constrained high structural stiffness. Another advantage of flexure members 126,128 with flexure joints 160,162 is that they do not generate particles as frictional joints do. This is an important factor in the success of an imprint lithography process as particles is particularly harmful to such processes.

Due to the need for fine gap control, examples presented herein requires the availability of a gap sensing method capable of measuring small gaps of the order of 500nm or less between the template and substrate.

Such a gap sensing method requires a resolution of about 50 nanometers, or less. Ideally, such gap sensing is provided in real-time. Providing gap sensing in real-time allows the gap sensing to be used to generate a feedback signal to actively control the actuators.

In an example, a flexure member having active compliance is provided. For example, Figure 17 depicts a flexure member, denoted generally as 400, including piezo actuators. Flexure member 400 is combined with a second flexure member to form an active orientation stage. Flexure member 400 generates pure tilting motions with no lateral motions at the template-substrate interface. Using such a flexure member, a single overlay alignment step allows the imprinting of a layer on an entire semiconductor wafer. This is in contrast to overlay alignment with coupled motions between the orientation and lateral motions. Such overlay alignment steps lead to disturbances in X-Y alignment, and therefore require a complicated field-to-field overlay control loop to ensure proper alignment.

In an example, flexure member 250 possesses high stiffness in the directions where side motions or rotations are undesirable and lower stiffness in directions where necessary orientation motions are desirable. Such an example provides a selectively compliant device. That is, flexure member 250 supports relatively high loads while achieving proper orientation kinematics between the template and the substrate.

With imprint lithography, it is desirable to maintain a uniform gap between two nearly flat surfaces (i. e., the template and the substrate). Template 150 is made from optical flat glass to ensure that it is substantially flat on the bottom. The template is patterned using electron beam lithography. The substrate (e. g., a semiconductor wafer), however, may exhibit a "potato chip" effect resulting in micron-scale variations on its topography. Vacuum chuck 478 (as shown in Figure 18), eliminates variations across a surface of the substrate that occur during imprinting.

Vacuum chuck 478 may serve two primary purposes. First, vacuum chuck 478 is utilized to hold the substrate in place during imprinting and to ensure that the substrate stays flat during the imprinting process. Additionally, vacuum chuck 478 ensures that no particles are present on the back of the substrate during processing. This is especially important to imprint lithography, as back-side particles may create flatness problems that ruin the device and decrease production yields. Figure 19A and 19B illustrate variations of a vacuum chuck suitable for these purposes.

In Figure 19A, a pin-type vacuum chuck 450 is shown as having a large number of pins 452. It is believed that vacuum chuck 450 eliminates "potato chip" effects as well as other deflections on the substrate during processing. A vacuum channel 454 is provided as a means of applying vacuum to the substrate to keep it in place. The spacing between the pins 452 is maintained such that the substrate will not bow substantially from the force applied through vacuum channel 454. At the same time, the tips of pins 452 is small enough to reduce the chance of particles settling on top of them.

Figure 19B depicts a groove-type vacuum chuck 460 with a plurality of grooves 462 across its surface. Grooves 462 perform a similar function to pins 454 of the pin-type vacuum chuck 450. As shown, grooves 462 take on either a wall shape 464 or a smooth curved cross section 466. The cross section of grooves 462 for groove-type vacuum chuck 462 is adjusted through an etching process. Also, the space and size of each groove is as small as hundreds of microns. Vacuum flow to each of grooves 462 is provided through fine vacuum channels across multiple grooves that run in parallel with respect to the chuck surface. The fine vacuum channels is formed along with grooves through an etching process.

Figure 18 illustrates the manufacturing process for both of pin-type vacuum chuck 450 and groove-type vacuum chuck 460. Using optical flat 470, no additional grinding and/or polishing steps is needed for this process. Drilling at determined locations on the optical flat 470 produces vacuum flow holes 472. Optical flat 470 is then masked and patterned 474 before etching 476 to produce the desired features (e. g., pins or grooves) on the upper surface of the optical flat. The surface of optical flat 470 is then treated 479 using well known methods.

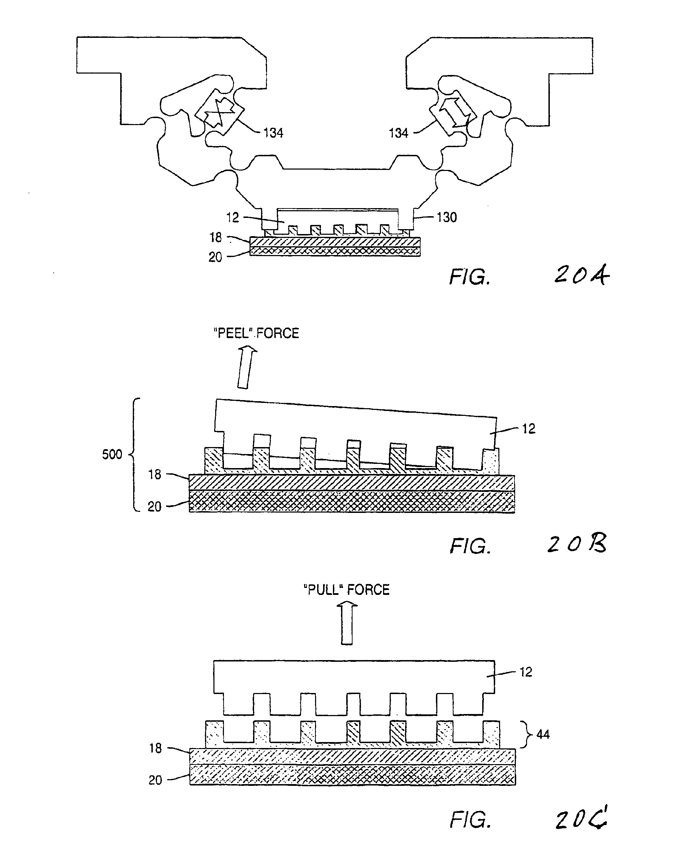

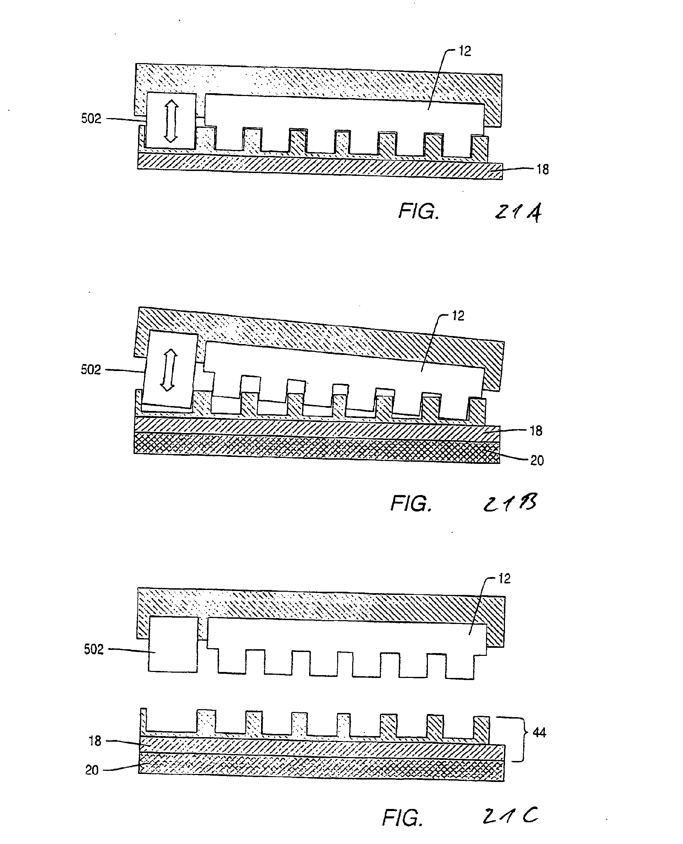

As discussed above, separation of template 150 from the imprinted layer is a critical, final step in the imprint lithography process. Since the template 150 and substrate is almost perfectly parallel, the assembly of the template, imprinted layer, and substrate leads to a substantially uniform contact between near optical flats. Such a system usually requires a large separation force. In the case of a flexible template or substrate, the separation is merely a "peeling process". However, a flexible template or substrate is undesirable from the point of view of high-resolution overlay alignment. In the case of a quartz template and a silicon substrate, the peeling process is not implemented easily. However, separation of the template from an imprinted layer is performed successfully by a "peel and pull" process. A first peel and pull process is illustrated in Figures 20A, 20B, and 20C. A second peel and pull process is illustrated in Figures 21A, 21B, and 21C. A process to separate the template from the imprinted layer may include a combination of the first and second peel and pull processes.

For clarity, reference numerals 12,18,20, and 40 are used in referring to the template, transfer layer, substrate, and curable substance, respectively, in accordance with Figures 1A and1B. After curing of the substance 40, either the template 12 or substrate 20 is tilted to intentionally induce an angle 500 between the template 12 and substrate 20. Orientation stage 250 is used for this purpose. Substrate 20 is held in place by vacuum chuck 478. The relative lateral motion between the template 12 and substrate 20 is insignificant during the tilting motion if the tilting axis is located close to the template-substrate interface. Once angle 500 between template 12 and substrate 20 is large enough, template 12 is separated from the substrate 20 using only Z-axis motion (i. e. vertical motion). This peel and pull method results in desired features 44 being left intact on the transfer layer 18 and substrate 20 without undesirable shearing.

A second peel and pull method is illustrated in Figures 21A, 21B, 21C. In the second peel and pull method, one or more piezo actuators 502 is installed adjacent to the template. The one or more piezo actuators 502 is used to induce a relative tilt between template 12 and substrate 20 (Figure 21A). An end of piezo actuator 502 is in contact with substrate 20. Thus, if actuator 502 is enlarged (Figure 21B), template 12 is pushed away from substrate 20; thus inducing an angle between them. A Z-axis motion between the template 12 and substrate 20 (Figure 21C) is then used to separate template 12 and substrate 20. An end of actuator 502 is surface treated similar to the treatment of the lower surface of template 12 in order to prevent the imprinted layer from sticking to the surface of the actuator.

## Claims

1. A device for holding an imprint lithography template, comprising:

    a body comprising an opening, wherein said opening is configured to receive said imprint lithography template;
    a piezo system coupled to said body to vary dimensions of said template, **characterized in that** it further comprises:

    a fixed supporting plate (5101) coupled to said body and separated from the template (5102), the supporting plate (5101) :

    being substantially transparent to an activating light used as curing agent during the imprint lithography process, and
    spanning the opening in the body in at least one direction, behind a template (5102) disposed within the holding device, to support an imprint force present in the imprint lithography process.

2. The device of claim 1, wherein the supporting plate (5101) is transparent to activating light.

3. The device of claim 1, wherein the supporting plate (5101) is formed from material selected from a set of materials consisting of quartz, Si02 and sapphire.

4. The device of claim 1, wherein the piezo system comprises a plurality of piezo actuators coupled to the body, wherein the piezo actuators are configured to apply a compressive force to the template disposed within the opening.

5. The device of claim 1, wherein said piezo system includes a piezo actuator coupled to selectively compress the template or to apply a tensile force to the template.

6. The device of claim 1, further including a vacuum system in fluid communication with said supporting plate to apply a vacuum to a template disposed in the device.

7. The device of claim 6, wherein the supporting plate comprises at least one vacuum opening configured to apply vacuum to the template, in particular between said supporting plate and said body.

8. The device of claim 6, wherein the body comprises at least one vacuum opening configured to apply vacuum a template disposed in the device.

9. The device of claim 1, wherein said supporting plate is configured to inhibit deformation of a template disposed in the device due to forces present during an imprint lithography process.

10. The device of claim 1, further comprising at least one mirror coupled to a surface of the body that faces inside the opening.

11. The device of claim 1, further comprising a reflective coating on at least one surface of the body that faces inside the opening.

**Patentansprüche**

1. Vorrichtung zum Halten einer Prägelithographievorlage, umfassend:

   einen Körper umfassend eine Öffnung, wobei die Öffnung konfiguriert ist, die Prägelithographievorlage aufzunehmen;
   ein Piezosystem, gekoppelt an den Körper, um Abmessungen der Vorlage zu variieren, **gekennzeichnet dadurch, dass** sie weiter umfasst:

   eine fixierte Trägerplatte (5101), gekoppelt an den Körper und getrennt von der Vorlage (5102), wobei die Trägerplatte (5101):

   für aktivierendes Licht, das während des Prägelithographieprozesses als Aushärtemittel verwendet wird, im Wesentlichen durchlässig ist, und
   die Öffnung im Körper in mindestens einer Richtung überspannt, hinter einer Vorlage (5102), angeordnet innerhalb der Haltevorrichtung, um eine Prägekraft zu tragen, die im Prägelithographieprozess vorhanden ist.

2. Vorrichtung nach Anspruch 1, wobei die Trägerplatte (5101) für aktivierendes Licht durchlässig ist.

3. Vorrichtung nach Anspruch 1, wobei die Trägerplatte (5101) aus einem Material gebildet ist, ausgewählt aus einer Menge von Materialien bestehend aus Quarz, $SiO_2$ und Saphir.

4. Vorrichtung nach Anspruch 1, wobei das Piezosystem eine Mehrzahl von Piezoaktuatoren umfasst, gekoppelt an den Körper, wobei die Piezoaktuatoren konfiguriert sind, eine komprimierende Kraft auf die Vorlage aufzubringen, die in der Öffnung angeordnet ist.

5. Vorrichtung nach Anspruch 1, wobei das Piezosystem einen Piezoaktuator beinhaltet, der gekoppelt ist, um wahlweise die Vorlage zu komprimieren oder um eine Zugkraft auf die Vorlage aufzubringen.

6. Vorrichtung nach Anspruch 1, weiter beinhaltend ein Vakuumsystem in Fluidverbindung mit der Trägerplatte, um ein Vakuum auf eine Vorlage aufzubringen, die in der Vorrichtung angeordnet ist.

7. Vorrichtung nach Anspruch 6, wobei die Trägerplatte mindestens eine Vakuumöffnung umfasst, die konfiguriert ist, um Vakuum auf die Vorlage aufzubringen, insbesondere zwischen der Trägerplatte und dem Körper.

8. Vorrichtung nach Anspruch 6, wobei der Körper mindestens eine Vakuumöffnung umfasst, die konfiguriert ist, um Vakuum auf eine Vorlage aufzubringen, die in der Vorrichtung angeordnet ist.

9. Vorrichtung nach Anspruch 1, wobei die Trägerplatte konfiguriert ist, um Deformation einer Vorlage, die in der Vorrichtung angeordnet ist, aufgrund von Kräften, die während eines Prägelithographieprozesses vorhanden sind, zu verhindern.

**10.** Vorrichtung nach Anspruch 1, weiter umfassend mindestens einen Spiegel, gekoppelt an eine Oberfläche des Körpers, der in die Öffnung hinein gewandt ist.

**11.** Vorrichtung nach Anspruch 1, weiter umfassend eine reflektierende Beschichtung auf mindestens einer Oberfläche des Körpers, die in die Öffnung hinein gewandt ist.


## Revendications

**1.** Dispositif conçu pour retenir un gabarit d'impression lithographique, comprenant :

un corps muni d'une ouverture, ladite ouverture étant configurée pour recevoir ledit gabarit d'impression lithographique ;
un système piézo-électrique, couplé audit corps afin de faire varier des dimensions dudit gabarit, **caractérisé par le fait qu'**il comprend, en outre :

une platine de support (5101) fixe reliée audit corps et séparée du gabarit (5102), ladite platine de support (5101) :

étant substantiellement transparente à une lumière d'activation utilisée en tant qu'agent de durcissement au cours du processus d'impression lithographique, et
coiffant l'ouverture pratiquée dans le corps, dans au moins une direction, derrière un gabarit (5102) placé à l'intérieur du dispositif de retenue, de manière à supporter une force d'impression présente au cours dudit processus d'impression lithographique.

**2.** Dispositif selon la revendication 1, dans lequel la platine de support (5101) est transparente à la lumière d'activation.

**3.** Dispositif selon la revendication 1, dans lequel la platine de support (5101) est formée à partir d'un matériau sélectionné au sein d'un groupe de matériaux comprenant du quartz, du $SiO_2$ et du saphir.

**4.** Dispositif selon la revendication 1, dans lequel le système piézo-électrique comprend une pluralité d'actionneurs piézo-électriques couplés au corps, lesdits actionneurs piézo-électriques étant configurés pour appliquer une force de compression au gabarit situé à l'intérieur de l'ouverture.

**5.** Dispositif selon la revendication 1, dans lequel ledit système piézo-électrique inclut un actionneur piézo-électrique couplé de manière à comprimer sélectivement le gabarit, ou à appliquer une force de tension audit gabarit.

**6.** Dispositif selon la revendication 1, incluant en outre un système de dépression en communication fluidique avec ladite platine de support, afin d'appliquer une dépression à un gabarit placé dans le dispositif.

**7.** Dispositif selon la revendication 6, dans lequel la platine de support comporte au moins un orifice de dépression configuré pour appliquer une dépression au gabarit, en particulier entre ladite platine de support et ledit corps.

**8.** Dispositif selon la revendication 6, dans lequel le corps comporte au moins un orifice de dépression configuré pour appliquer une dépression à un gabarit placé dans le dispositif.

**9.** Dispositif selon la revendication 1, dans lequel ladite platine de support est configurée en vue d'empêcher la déformation d'un gabarit placé dans le dispositif, provoquée par des forces présentes au cours d'un processus d'impression lithographique.

**10.** Dispositif selon la revendication 1, comprenant en outre au moins un miroir couplé à une surface du corps qui est en regard de l'intérieur de l'ouverture.

**11.** Dispositif selon la revendication 1, comprenant en outre un revêtement réfléchissant sur au moins une surface du corps qui est en regard de l'intérieur de l'ouverture.

14 ⌐

12

18 —

16

20

FIG. 1A

14 ⌐

12

18 —

16

20

FIG. 1B

30 ⟶

14

12

31 ⟶

13

18

20

FIG. 2A

30 ⟶

12

40

FIG. 2B

32

30

*FIG. 2C*

40

18

12

20

30

12

18

44

20

*FIG. 2D*

30

44

20

*FIG. 2E*

50

```
┌─────────────────────────────────────┐
│  Course orient template and substrate (may be │
│           done periodically).        │
│                 52                   │
└─────────────────────────────────────┘
                    ↓
┌─────────────────────────────────────┐
│      Dispense Liquid onto substrate. │
│                 54                   │
└─────────────────────────────────────┘
                    ↓
┌─────────────────────────────────────┐
│   Control Spacing between template and │
│    substrate to form a uniform gap.  │
│                 56                   │
└─────────────────────────────────────┘
                    ↓
┌─────────────────────────────────────┐
│       Close gap to desired height    │
│                 58                   │
└─────────────────────────────────────┘
                    ↓
┌─────────────────────────────────────┐
│              Cure liquid             │
│                 59                   │
└─────────────────────────────────────┘
                    ↓
┌─────────────────────────────────────┐
│      Separate template from substrate │
│                 60                   │
└─────────────────────────────────────┘
                    ↓
┌─────────────────────────────────────┐
│     Etch to remove residual base layer. │
│  (Oxygen etch to transfer layer if higher aspect │
│            ratio desired.)           │
│                 62                   │
└─────────────────────────────────────┘
```

*FIG. 3*

FIG. 4

FIG. 5

FIG. 6

FIG. 7

FIG. 8

Start Imprint

↓

Load a substrate

↓

Initial orientation alignment

↓

Measure overlay error

Measure magnification error

↑

Body thermal control of substrate or template

←N—

Is magnification error ≤ target ?

↓ Y

Measure theta error

Is theta error ≤ target ?

—N→

Theta rotation compensation

↓ Y

Measure placement error

↑

XY adjustment using XY table or thermal control

←N—

Is placement error ≤ target?

↓ Y

Step and repeat imprinting process

↓

Unload a substrate

↓

Finish Imprint

*FIG.* 9

Start Imprint

↓

Load a substrate

↓

Initial orientation alignment

↓

Measure overlay error

Measure gap

↓

Acquire overlay mark images while moving microscope up and down for the gap height

Measure magnification error

Body thermal control of substrate or template

←N— Is magnification error ≤ target ?

Y

Is theta error ≤ target ?

—N→ Theta rotation compensation

Measure theta error

Y

Measure placement error

XY adjustment using XY table or thermal control

←N— Is placement error ≤ target? —Y→ Expose the imprinting field

Measure placement error due to orientation

Move to a next field and perform orientation alignment

←N— Are all fields exposed?

Y

↓

Finish Imprint

FIG. 10

FIG.    11

FIG. 12

EP 1 840 649 B1

FIG. 13A

FIG. 13B

FIG. 14

EP 1 840 649 B1

FIG. 15

254
Template-wafer
interface

C

150
Template

Joint 2

Joint 3

$\alpha_1$

300

310

314

$\alpha_2$

312

Joint 1

Joint 4

FIG. 16

134

134

250

Joints

130

Joints

150

400

FIG. 17

mask (holes/grooves)

470

Optical Flat

472

Drilling of vacuum
flow holes

474

Pattern Generation

FIG. 18

478

Surface treatment

476

Etching

452    454    452

450

Vacuum flow

452

FIG. 19A

462

460

462

462

FIG. 19B

12 —
18 —
20 —
134
134
130

FIG.    20A

"PEEL" FORCE

500
18 —
20 —
12

FIG.    20B

"PULL" FORCE

18 —
20 —
12
} 44

FIG.    20C

FIG. 21A

FIG. 21B

FIG. 21C

5101

5102

5103          5103

FIG.    22 A

5103

5103          5103

5103

FIG.    22 B

material 1

d

$\rho_{12}$

material 2

material 3

$\rho_{23}$

FIG.    23

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4694703 A, Routson
- US 4062600 A, Wyse
- US 4414750 A
- US 4337579 A
- US 4155169 A
- US 4355469 A
- US 4202107 A
- US 4098001 A
- US 5204739 A

**Non-patent literature cited in the description**

- **WHITE D L et al.** Novel alignment system for imprint lithography. *JOURNAL OF VACUUM SCIENCE AND TECHNOLOGY: PART B,* November 2000, vol. 18 (6), 3552-3556